# EUROPEAN PATENT APPLICATION

(11) **EP 4 711 791 A2**
(43) Date of publication of application: **18.03.2026**
(21) Application number: 25202408.8
(22) Date of filing: 16.09.2025
(51) Int. Cl.: G01R 33/00, G01R 33/028

(54) **MAGNETIC FIELD SENSOR AND METHOD OF MANUFACTURING THE SAME**

(30) Priority: 17.09.2024 CZ 20240358; 17.09.2024 CZ 202442234 U
(71) Applicant: Západoceská univerzita v Plzni, 301 00 Plzen (CZ); Ustav fyziky plazmatu AV CR, v.v.i., 18200 Praha 8 (CZ); Elceram a.s., 50003 Hradec Kralove (CZ)
(72) Inventor: Turjanica, Pavel, 34034 Planice (CZ); Reboun, Jan, 33701 Rokycany (CZ); Duran, Ivan, 25219 Drahelcice (CZ); Entler, Slavomir, 25756 Chrastany (CZ); Simonovsky, Marek, 50006 Hradec Kralove (CZ); Stepan, Lukas, 50304 Cernozice (CZ); Johan, Jan, 50327 Roudnice (CZ)
(74) Representative: Sedlák, Jirí

(57) **Abstract**

The present invention relates to a sensor for measuring magnetic fields in extreme conditions, particularly at high ambient temperatures and under exposure to intense ionising radiation. The invented sensor consists of a sandwich structure of substrates (1) made of ceramic material. In the gaps between the substrates (1) in the sandwich structure, fired printed surface patterns (2, 3, 8) are formed on the substrates (1), which form the individual turns of the resulting measuring coil of the sandwich structure. The manufacturing process for the invented sensor is simple, as surface patterns are first printed onto individual substrates (1), which are then fired, and subsequently the substrates (1) are assembled into a sandwich structure, fixed by means of fixation points (5, 6), and the sandwich structure is then hardened by re-firing. Part of the invention is the structure of the fired patterns, which allows the sensor to achieve maximum separation of a useful signal in the sensing axis relative to other axes and to resist other physical effects caused by radiation.

## Description

### Field of the Invention

The present invention relates to a sensor for measuring magnetic fields in extreme conditions, particularly at high ambient temperatures and under exposure to strong ionising radiation.

### Background of the Invention

In general, a sensor is defined as a device that measures a specific physical or technical variable and converts it into a signal that can be transmitted remotely and processed in measuring and control systems. Most often, this is an electrical signal, i.e. time characteristic of electrical voltage or electrical current.

A magnetic field sensor is used to measure the intensity of the magnetic field passing through the sensor, whereby the action of a variable magnetic field induces an electrical voltage in the sensor, which is conducted from the sensors's electrical contacts via electrical conductors for evaluation. Electrical induction takes place in an electrical conductor that is wound into a coil in the sensor.

It is a well-known fact that measurement accuracy, or the ability to measure, is influenced by the conditions prevailing during sensor measurement. Extreme conditions can include high temperatures and intense ionising radiation (gamma radiation, neutron radiation, etc.), e.g. in thermonuclear power reactors, where magnetic field sensors are exposed to operating temperatures of up to around 500°C and total neutron doses of up to around 10^25 n/m^2.

Currently, there are no accurate magnetic field sensors that measure magnetic fields in extreme conditions, i.e. at temperatures around 500°C and with a total neutron dose of around 10^25 n/m^2, that are also resistant to other radiation and thermoelectric effects.

Well-known non-ceramic magnetic field sensors with protective insulation for electrical conductor windings are functional at relatively low temperatures compared to the actual conditions prevailing in thermonuclear power reactors. The highest operating temperature of approximately 250°C is permitted by polyimide insulation (e.g. Kapton) of electrical winding conductors.

Magnetic field sensors with uninsulated electrical conductor wound on ceramic carriers, or sensors made of solid mineral-insulated cables, known as "MIC", can withstand higher operating temperatures. Specifically, this is a core electrical conductor that is placed in a steel sheath and, for electrical insulation, is surrounded by ceramic powder, typically based on MgO or Al₂O₃.

The disadvantages of these sensors for measuring magnetic fields at high operating temperatures are that they usually only allow for the effective implementation of a single layer of turns. MIC sensors are significantly massive. Both of the above factors lead to a reduction in the number of turns in the sensor, resulting in low sensitivity of the coils made of electrical conductors to slow changes in the magnetic field. Even in the case of multiple layers of turns, the coil still has considerable sensitivity to field changes in the lateral axes due to its winding length, which, given the ratio of magnetic field forces, may even exceed the actual sensed signal.

For the reasons mentioned above, ceramic coil technology known as "LTCC *(Low Temperature Co-fired Ceramic*)" has been developed over the last few years, which achieves higher sensitivity to slow changes in the magnetic field and minimizes sensitivity in other winding axes. However, the development of LTCC coils encountered technological problems, resulting in the need to use silver or gold for the material of coils, neither of which is entirely suitable for environments with ionising radiation. Under the influence of neutron radiation, silver becomes highly activated, which is undesirable, particularly in terms of subsequent handling or disposal. Silver also has a very high value for neutron capture compared to Cu and other metals, so sensors based on LTCC technology have much higher sensitivity to temperature gradients. When gold is used for conductive layers in LTCC, there is also a risk of so-called "transmutation", changing its physical and chemical properties and creates local thermoelectric cells in the sensor, distorting the output signal. Another known shortcoming is that, due to their unstable structure, magnetic field sensors based on LTCC technology have a limited operating temperature of 250°C.

Another problem is electrical phenomena and changes in sensor properties caused by radiation. These are the RIC, RIED, RIEMF, RIEMF, RITES, and TIEMF effects. These technical abbreviations for effects are explained below.

Neutron and gamma radiation causes a strong ionisation effect in the sensor material, i.e. release of free energetic electrons. Free electrons can be generated as a result of direct interaction of gamma rays with an insulator, either through the Compton effect, the photoelectric effect, or the pair production effect. Prompt electrons are also indirectly generated by neutrons through radiative capture of neutrons, which emit energetic gamma radiation. Delayed electrons can be generated after the radioactive beta decay of an unstable isotope produced by neutron capture. These processes generate a current source that can affect the electrical behaviour of the sensor through various radiation effects.

The RIC (radiation-induced conductivity) effect refers to a reduction in the insulating function of the substrate. RIC is proportional to the ionisation rate and disappears when the radiation flux stops. It can cause signal leakage and interference.

The RIED (radiation-induced electrical degradation) effect causes the substrate to gradually lose its insulating ability under the influence of radiation flux, especially at high temperature and applied voltage. Eventually, when a certain threshold dose is reached, the substrate may completely lose its insulating character.

The RIEMF (radiation-induced electromotive force) effect creates a current source across the insulator between the sensor conductor and the grounded structure, which can lead to the development of voltage or an increase in charge on the sensor. This causes lower stability of all measured weak signals.

The RITES (radiation-induced thermoelectric sensitivity) effect gradually changes the Seebeck or thermoelectric coefficient due to uneven transmutation of the conductor caused by neutrons (either due to uneven distribution of impurities and/or neutron field).

The TIEMF (temperature-induced electromotive force) effect causes voltage to be developed as a result of these changes in the thermoelectric effect when there is a temperature gradient across the sensor.

Radiation and temperature-induced electrical effects result in false voltages at the sensor terminals, which, although in the order of several µV, can affect the accuracy of the final measurement.

Last but not least, it is necessary to solve the problem of so-called "swelling", or the swelling of Al₂O₃ caused by neutron radiation flux. In high doses (above 10^23n/m^2), radiation leads to changes in the physical dimensions of the substrate and to the disruption of conductive patterns of the sensor.

The object of the invention is to create a magnetic field sensor that would function reliably in extreme conditions of high operating temperatures up to at least 500°C and intense ionising radiation (with a total neutron dose of at least 10^23 n/m^2), which would not have a massive design like known sensors based on MIC technology, which would have high sensitivity in the sensing axis and maximum signal suppression in other axes, compensate as much as possible for the RIC, RIED, RIEMF, RIEMF, RITES, and TIEMF effects, would not suffer from swelling, and would have a simple design allowing for easy and mass production.

### Summary of the Invention

The stated object is solved by means of a magnetic field sensor created according to the invention described below.

A magnetic field sensor consists of at least one wound electrical conductor to induce an electrical voltage by a penetrating alternating magnetic field. Furthermore, the sensor consists of an insulation arranged between the turns of a wound electrical conductor to prevent mutual contact between the turns. Furthermore, the sensor consists of electrical contacts arranged at the ends of a wound electrical conductor to connect an external device to the magnetic field sensor.

The essence of the invention is that the invented magnetic field sensor consists of at least two substrates made of ceramic insulating material arranged in a sandwich structure. The sandwich structure allows for modular assembly during the production of the invented sensor, so that the appropriate choice of the number of substrates provides sufficient space for the wound electrical conductor.

Furthermore, the essence of the invention is that the wound electrical conductor consists of at least one surface pattern arranged on at least one side of the substrates. This is significant because it is possible to stack surface patterns on top of each other, thereby increasing the sensitivity of the invented sensor to slow changes in the magnetic field. The increased sensitivity is due not only to the greater number of surface patterns, but also to their arrangement in space and the shape of the winding, i.e. it depends on the individual layers of the sandwich structure.

Furthermore, the essence of the invention is that the substrates have metal-plated holes for electrical connection between their back and front sides, with the electrical contacts arranged on the outside of the sandwich structure. Metal-plated holes enable electrical connection of individual layers (substrates) in the sandwich structure, all the way to the electrical contacts.

The last essential technical characteristic of the invented sensor is that the ceramic insulating material of the substrates is from the Al₂O₃, AlN, or MgAl₂O₄ group, and the surface pattern is made of material from the Cu, Pt, or W group.

These materials can withstand high operating temperatures and high doses of neutron ionising radiation, and are vacuum compatible, behaving similarly under extreme loads so that no damage occurs due to factors such as different volumetric expansion. Ceramic materials are strong enough to provide solid and stable support for surface patterns, while copper conducts induced electric current well and is reluctant to transmute when bombarded with neutrons from ionising radiation. The invented sensor is capable of continuous operation at temperatures of at least 500°C in an oxygen-free atmosphere, and no gas is released from the sealed structures of the material in a vacuum.

In a preferred embodiment of the invented sensor, adjacent surface patterns overlap by a maximum of 20%. This brings the benefit of limiting the inter-turn capacitance of the coils, which would have a negative effect on the measurement signal.

In another preferred embodiment of the invented sensor, at least one fixation point is created between adjacent substrates, located outside the surface patterns, which is made of the material of the surface pattern. The fixation point firmly holds adjacent substrates together, and when the same material is used, this material performs like the rest of the surface patterns in extreme conditions, thereby reducing the risk of damage to the sensor due to local stresses. Since the fixation points are outside the surface patterns, they do not significantly affect the processes taking place on the windings formed by the surface patterns. Since these are small surface points rather than larger structures, there is no formation of stray currents or local short circuits.

In an alternative preferred embodiment of the invented sensor, the fixation point is included in adjacent surface patterns to electrically connect them.

In another preferred embodiment of the invented sensor, the sandwich structure comprises at least one additional substrate without a surface pattern, wherein the additional substrate is arranged at the beginning and/or at the end and/or inside the sandwich structure. The outer additional substrates are used to protect the surface conductive patterns from mechanical damage. The internal additional substrate is used according to the requirements of specific designs of the resulting 3D shape of the coil assembled from surface patterns arranged in a sandwich structure according to the circumstances of use of the invented sensor, or changes in the electrical properties of the sensor (e.g. inter-turn capacitance).

The additional substrate arranged at the beginning and/or at the end of the sandwich structure on the side facing away from the sandwich structure is preferably provided with a field of points or a comb structure, made of electrically conductive material. The field of points, or comb structure, compensates for the effects of electron migration between layers caused by ionising radiation. The outer surface patterns are isolated on one side, with no neighbour from which electrons knocked out by ionising radiation could come, resulting in a local imbalance in the part of the winding, which is manifested by the generation of local electrical voltage. At the same time, this imbalance creates a current source between the sensor conductor and the grounded structure (RIEMF). If the outer surface patterns are adjacent to a field of points or a comb structure, it behaves as if there were another surface pattern in the vicinity, whereby the generated electric current of electron migration between the turns and the field of points remains in balance, and the imbalance is transferred to the field of points or comb structure outside the sensor.

In order to establish a balance in the case of electron migration, it is advantageous if the total volume of the material forming the field of points or comb structure is equal to the volume of the adjacent surface pattern with a tolerance of no more than ± 20%.

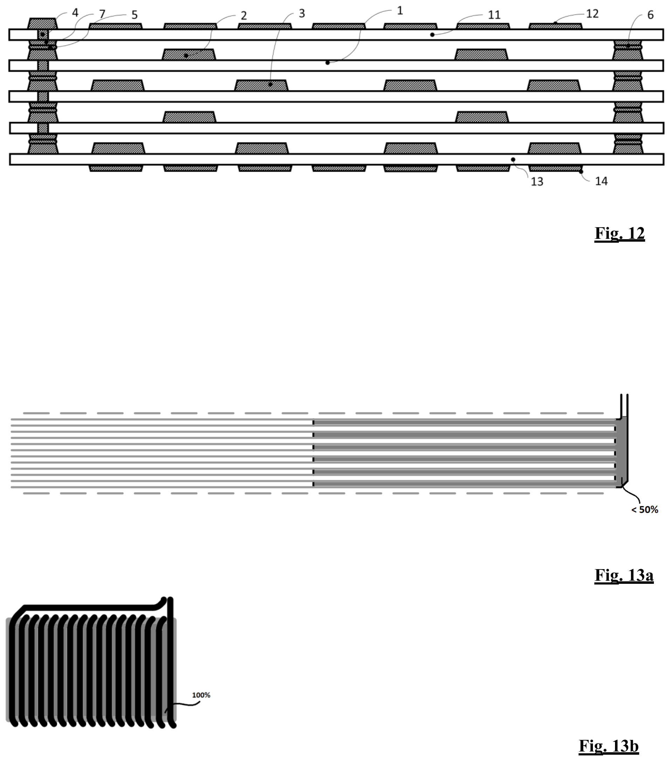

In another preferred embodiment of the invented sensor, the surface patterns are arranged in a row from the front side of the sandwich structure to the back side of the sandwich structure, connected into a single loop. At the same time, the combined projection of surface patterns in a direction perpendicular to the sensing axis of the sensor forms a magnetically active continuous surface area of no more than 50% of the total area of the projection of surface patterns. This gives rise to a comb-like pattern on the magnetically active surface, the essence of which is illustrated in Fig. 13a. This brings the benefit that the sensor is less sensitive to magnetic fields in undesirable directions in three-dimensional space compared to non-optimised windings of sensors or conventional wire windings on the coil former (Fig. 13b).

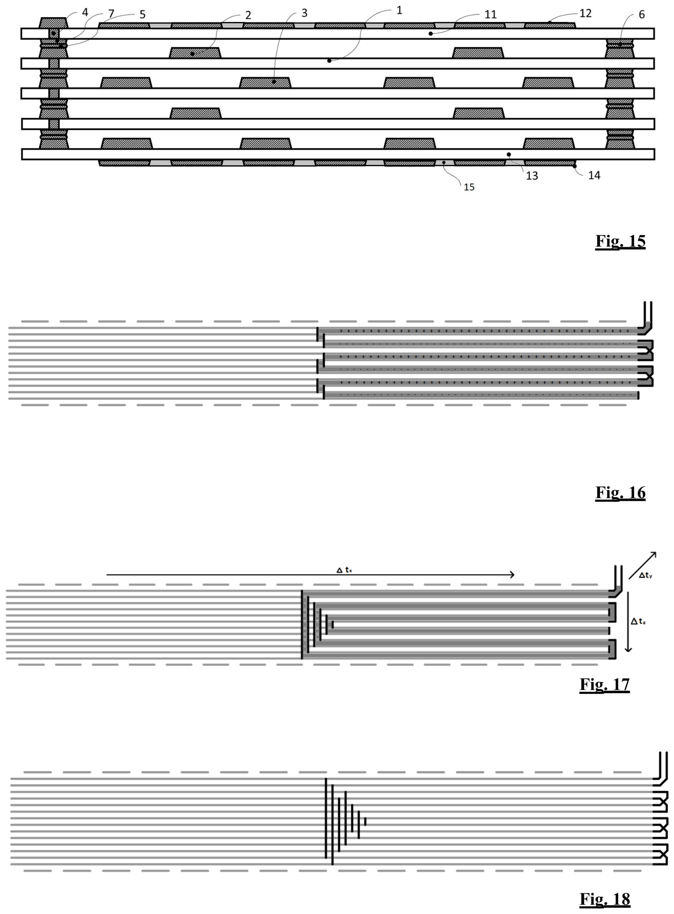

In another preferred embodiment of the invented sensor, the surface patterns, which are arranged in a row from the front side of the sandwich structure to the back side of the sandwich structure, are connected into a single loop, in which the surface patterns at odd positions of the sandwich structure are first connected, a transition to the pattern at the even position of the sandwich structure takes place at the last position, and then they are connected back after the even positions. If the number of layers of surface patterns is even, there is a regular alternation of combined projections of surface patterns in a direction perpendicular to the sensing axis of the sensor, with a positive signal increment from the undesirable magnetic field and a negative signal increment from the undesirable magnetic field, which ideally negates. This results in so-called "layer twisting", which further reduces the effective area of the combined projection of surface patterns to the level <5% of the total area of the projection of surface patterns in the given secondary axis, see Fig. 16. If the number of surface patterns is odd, mutual compensation of positive and negative increments is not as effective, but a significant portion of the unwanted signal is still compensated.

Another preferred embodiment of the invented sensor consists of surface patterns arranged in a row from the front side of the sandwich structure to the back side of the sandwich structure, connected into a single loop, in which the surface patterns in the first half of the order are connected to the surface patterns located in the opposite positions of the second half of the order. If the number of layers of surface patterns is even, the first surface pattern is connected to the last surface pattern, then the loop returns and continues to the second surface pattern in order, which is connected to the penultimate surface pattern, and so on, until all surface patterns are connected in the loop. If the number of surface patterns is odd, the winding in the order of the first surface pattern is connected to the electrical contact (begins) in the middle part of the sensor, not at its edge. This is advantageous because the effect of temperature gradients Δtx, Δty, Δtz (due to the formation of local impurities through transmutations) influences the formation of local thermoelectric voltages (TIEMF) along the winding sections in individual surface patterns. Due to the fact that the temperature gradient and the amount of transmuted material vary in different parts of the sensor, different thermoelectric cells are created. It can be assumed that transmutations and temperature gradients will be more similar in close layers and more different in more distant layers. Targeted alternation/mixing of the order of distant and closer layers increases the probability of mutual cancellation of individual local thermocouples in the resulting signal if there is a locally higher occurrence of TIEMF in the sensor. At the same time, undesirable loops that increase the surface area of the combined projection of surface patterns must not be created. This is best achieved by alternating pairs of sensor layers, see Fig. 17.

In addition, the invention comprises a method of manufacturing the invented magnetic field sensor.

The essence of the manufacturing method is that surface patterns are first created on substrates using selective printing and firing method, with materials from the Cu, Pt, and W group being used to print the patterns. The individual substrates with the fired surface patterns are then assembled into a sandwich structure and the surface patterns are connected to form a continuous electrically conductive path, with the sandwich structure also being fixed in place using additional pads.

The manufacturing method is easy to implement, as individual substrates with surface patterns can be manufactured without major difficulties using conductive paste printing (based on Cu, Pt, W) and firing in a furnace (without oxygen for Cu, with oxygen for Pt, W). Assembling individual layers into a sandwich structure does not require advanced technology. In addition, it is advantageous that damaged parts can be detected and discarded during assembly, so that the factory frequency of malfunctioning sensors is minimal.

One of the main advantages of the invention is that individual substrates with surface patterns (Cu, Pt, or W material) are layered on top of each other to create a 3D sensor with a higher number of turns than is possible on a single substrate. The electrical and mechanical connection of individual substrates is achieved by means of a paste printed and fired in the same way as when creating surface patterns of the sensor on substrates, i.e. individual substrates with surface patterns are first printed and fired, followed by application of the paste (Cu, Pt, or W), with the individual substrates being layered on top of each other in a sandwich structure in an assembly device and then fired in a furnace under the same conditions as the individual substrates. Unlike LTCC technology, small gaps are created between the layers of the substrate. This has the benefit of minimizing the so-called "trapped gas" in the sensor (unacceptable for fusion reactors) and at the same time limiting the RIED effect.

Another advantage of the invention is that the 3D structure of the sensor allows adjacent surface patterns to alternate so that they do not overlap, achieving a low inter-turn capacitance and thus a high natural resonance frequency while increasing the uniformity of the flow of short-circuit β-electrons between individual turns.

Another advantage of the invention is that the surface patterns in the individual layers of the sandwich structure are connected in such a way that the resulting sensor exhibits a significant active area in only one axis. In the remaining two axes, the active area is minimized thanks to the 3D structure of connection of the individual layers of the sensor (so-called "twisted alternation of layers"). The sensor therefore detects the magnetic field in one of the three axes with high sensitivity, while in the others it is significantly suppressed compared to a conventional design of the winding.

Another advantage of the invention is that the order of the sensor layers in the sandwich structure is selected, when connecting sections of surface patterns, with regard to the compensation of thermoelectric phenomena in the form of so-called "nuofilar ordering of their connection" in order to minimize the so-called RITES and TIEMF effects. This means that the surface patterns are not connected in accordance with the order in the sandwich structure (from first to last), but with alternately particular order so that the individual sections of the loop (surface patterns at different positions in the sandwich structure) compensate for each other.

Another advantage of the invention is that the sensor on the back and front sides of the sandwich structure with additional substrates is provided with a compensation layer that minimizes the RIEMF (Radiation Induced Electromotive Force) and RIC (Radiation Induced Conductivity) effects. The covering additional substrate does not contain a conductive surface patterns of the sensor, but contains an ordered field of points or a comb structure pattern, and is designed to compensate for the flow of beta electrons caused by neutrons in the conductive surface patterns of the turns of the sensor in the inner layers of the sandwich structure. The additional substrate is also used to mechanically protect the conductive surface patterns of the sensor.

### Explanation of drawings

The present invention will be explained in detail by means of the following figures where:
- Fig. 1a: shows three separate substrates with different variants of the surface pattern,
- Fig. 1b: shows stacking of the substrate on top of each other to form a sandwich structure,
- Fig. 2a: shows the invented sensor in the top view,
- Fig. 2b: shows the invented sensor in the side view,
- Fig. 2c: shows the invented sensor in the axonometric view,
- Fig. 3a: is an X-ray image of the assembled coil of the invented sensor in the top axonometric view,
- Fig. 3b: is an X-ray image of the assembled coil of the invented sensor in the side axonometric view,
- Fig. 3c: is an X-ray image of the assembled coil of the invented sensor in the front view,
- Fig. 4: shows a transparent plan view of the first two layers of the sandwich structure of the invented sensor; for simplicity, only one turn is shown,
- Fig. 5: shows a schematic representation of the technological design of the invented sensor in the side view with surface patterns located only on the front side of the substrates and with fixation points at the metal-plated holes and outside the surface patterns,
- Fig. 6: shows a schematic representation of the technological design of the invented sensor depicted in Fig. 5, with the difference that the contact surfaces at the fixation points are shown,
- Fig. 7: shows a schematic representation of the technological design of the invented sensor depicted in Fig. 5, with the difference that the fixation points are located across the entire surface of the substrate,
- Fig. 8: shows a schematic representation of the technological design of the invented sensor in the side view with surface patterns located simultaneously on the front and back sides of the substrates,
- Fig. 9: shows a schematic representation of the technological design of the invented sensor in the side view with the upper additional substrate,
- Fig. 10: shows a schematic representation of the technological design of the invented sensor in the side view with upper and lower additional substrates,
- Fig. 11: shows a transparent plan view of the first two layers of the sandwich structure of the invented sensor and the field of points for compensation of the flow of β-electrons knocked out by neutron flux,
- Fig. 12: shows a schematic representation of the technological design of the invented sensor depicted in Fig. 11 in the side view,
- Fig. 13a: shows a diagram of an example connection of surface patterns into the resulting loop - coil in the sensor depicted in Figs. 11 and 12, and at the same time shows a combined projection of surface patterns in a direction perpendicular to the sensing axis of the sensor,
- Fig. 13b: shows the combined projection of a wound coil in a direction perpendicular to the sensing axis of the sensor,
- Fig. 14: shows a schematic transparent plan view of the first two layers of the sandwich structure of the invented sensor and further the comb structure for compensation of the flow of β-electrons knocked out by neutron flux and for discharge of the generated electric charge,
- Fig. 15: shows a schematic representation of the invented sensor depicted in Fig. 14 in the side view,
- Fig. 16: shows a schematic example of so-called "twisted connection of surface patterns of the sensor" to minimize signal sensitivity from unwanted directions,
- Fig. 17: shows a schematic example of the implementation of alternation of surface patterns of the sensor to minimize the influence of radiation-induced thermoelectric phenomena,
- Fig. 18: shows a diagram of the invented sensor combining twisting and specific alternation of layers of the sensor and layers for compensation of the flow of β-electrons (nuofilar winding).

### Example of the invention embodiments

It shall be understood that the specific cases of the invention embodiments described and depicted below are provided for illustration only and do not limit the invention to the examples provided here. Those skilled in the art will find or, based on routine experiment, will be able to provide a greater or lesser number of equivalents to the specific embodiments of the invention which are described here.

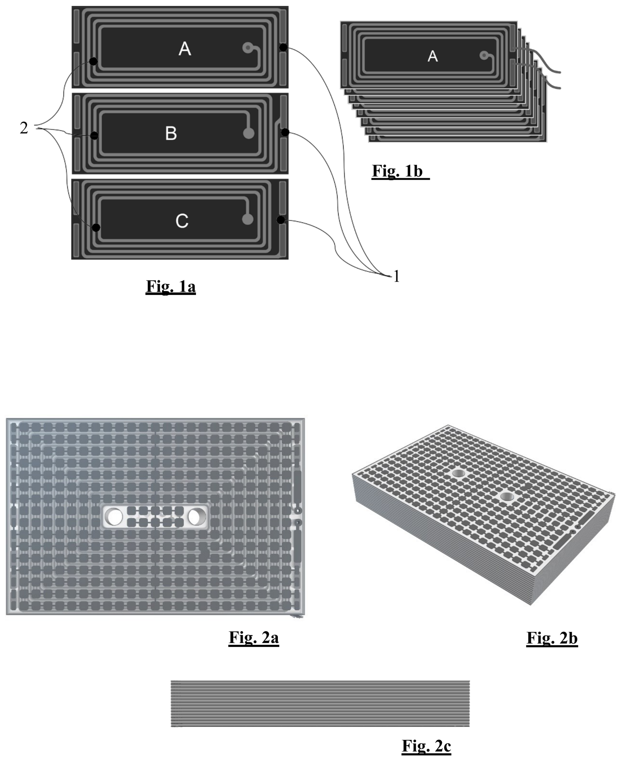

Fig. 1a shows three substrates 1 with three different surface patterns 2 in variants A, B, and C. Fig. 1b illustrates how the individual substrates 1 are stacked on top of each other to form a sandwich structure with eights layers.

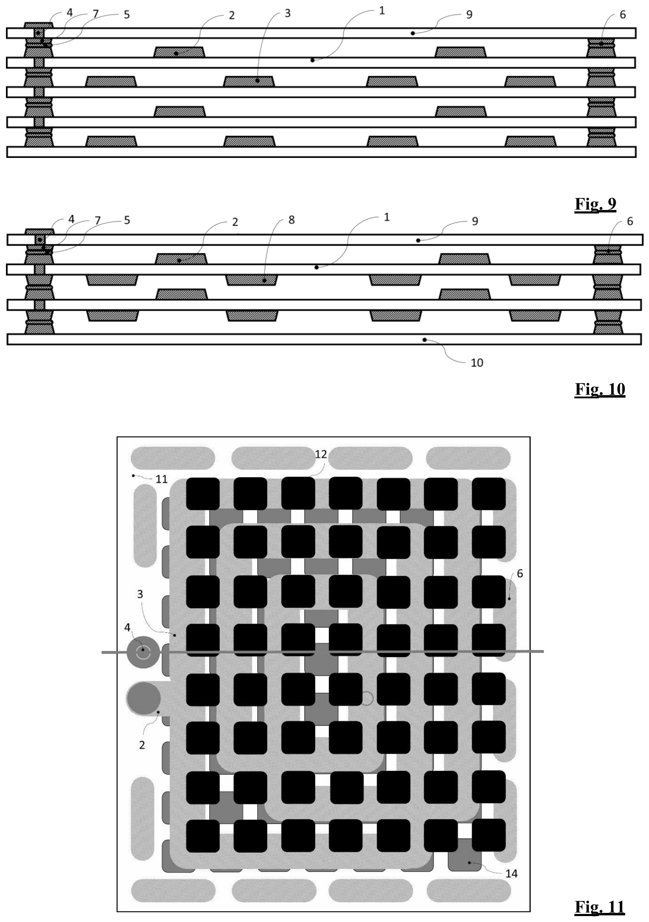

Figs. 2a to 2c show different views of the invented sensor, which has the sandwich structure consisting of several substrates 1. A pair of assembly holes passes through the sandwich structure. This is an optional technical characteristic that does not affect the function or durability of the invented sensor. Furthermore, the top cover layer with printed points is visible, which will be discussed in more detail hereunder in connection with Fig. 11.

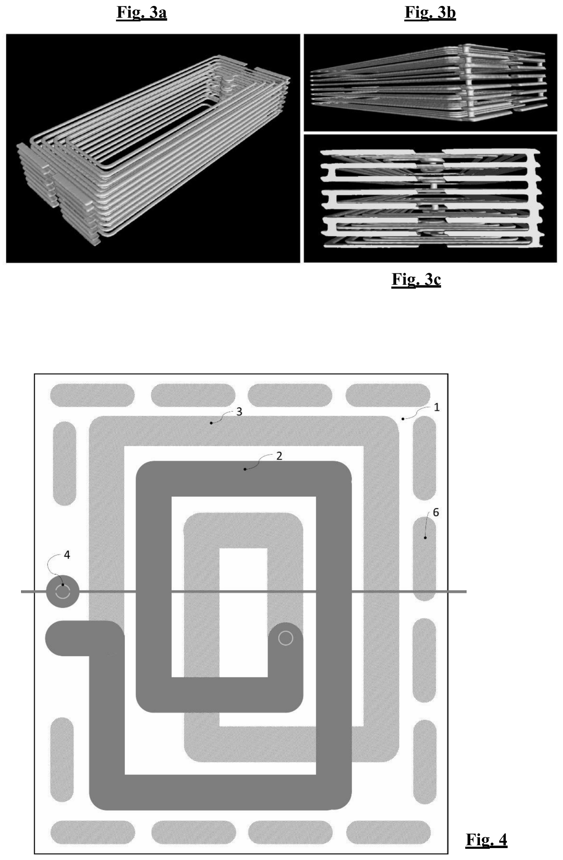

Figs. 3a to 3c show an X-ray image of the invented sensor, in which only the surface patterns 2 are visible from the sandwich structure. The figures show that the surface patterns 2 are connected in the sandwich structure to form a single wound electrical conductor - a coil - and that they do not touch each other.

### Example 1

The invented sensor consists of n-number of ceramic substrates 1 made of a material from the Al₂O₃, AlN, or MgAl₂O₄ group, with electrically conductive surface patterns 2 arranged on the front side of the substrate and connected by conductive paste at a predetermined location, i.e., at a fixation point 5 extending into surface patterns 2 and 3. The sensor of Example 1 is designed to measure non-stationary magnetic field and is capable of continuous operation at temperatures of at least 500°C. The sensor contains only materials that are not easily activated by neutron flux (i.e. materials such as Ag, Ni, Co, etc., are not used) and are compatible with vacuum. Both the ceramic substrate and the conductive surface patterns of the sensor are made of materials that are resistant to neutron flux up to at least 10^23 n/m^2.

On the front side of the first substrate 1, there is a surface pattern 2 with 1-m turns. On the front side of the second substrate 1, there is another surface pattern 3 with 1-m turns, connecting to the end of pattern 2 of the previous layer of the sandwich structure and forming turns in the same direction as the first pattern 2. On the front side of the third substrate 1, there is a surface pattern with 1-m turns and a topology similar to that of the sensor on the first layer. On the front side of the fourth substrate 1, there is a surface pattern 3 with 1-m turns and a topology similar to that of the sensor on the second layer. In this way, a composition of n-layers of ceramic substrates 1 with surface patterns 2 and 3 is created, resulting in a single 3D sensor. To minimize the inter-turn capacitance of the sensor, the turns of the patterns on the odd layers of substrate 1 are located at the gaps between the turns of the patterns located on the even layers of substrate 1.

The electrical and mechanical connection of surface patterns 2 and 3 on individual substrates 1 is achieved using conductive paste printed and fired in the same way as when creating sensor patterns on substrates 1. First, individual substrates 1 are printed and fired with surface patterns 2 and 3 created using thick-film pastes, preferably based on Cu, Pt, or W, including conductively metal-plated holes 4 in ceramic substrates 1, then another layer of conductive paste is applied to the already fired conductive patterns 2 and 3, i.e. fixation points 5 are created, which are also used for electrically conductive connection. The individual substrates 1 are stacked on top of each other in an assembly device and then fired in a furnace under the same conditions as the individual substrates 1. The 3D structure of the sensor, with a distance between individual layers of flat coils greater than 0.3 mm, allows for low inter-turn capacitance and thus a high natural resonance frequency. Furthermore, there are fixation points 6, preferably made of fired Cu, Pt, or W paste, without electrical connection between patterns 2 and 3.

Fig. 4 shows a plan view of the first two layers of the sandwich structure, specifically surface patterns 2 and 3 forming the coil windings, and Fig. 4 shows a side section of the sandwich structure of the sensor.

### Example 2

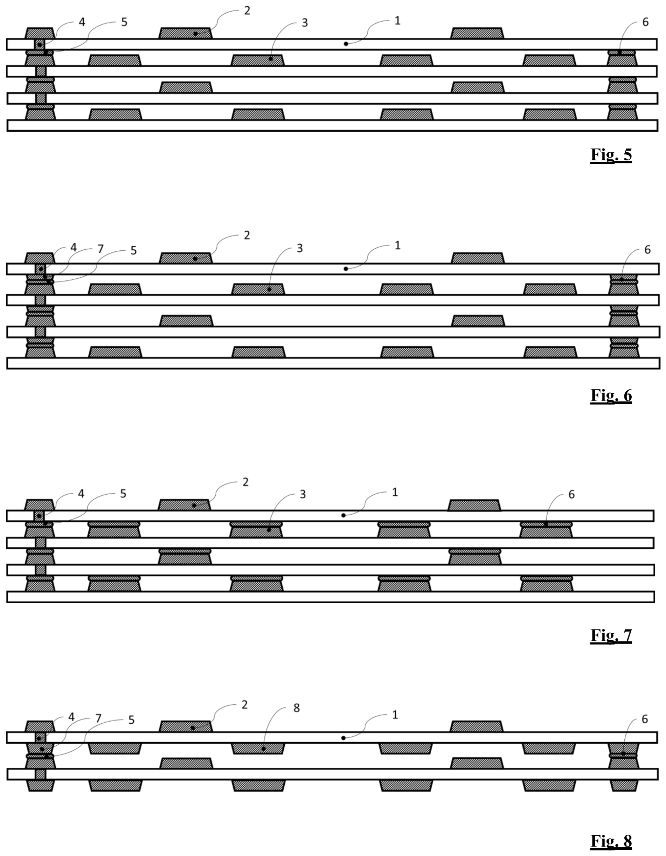

Fig. 6 shows a sensor with a sandwich structure, which is provided with contact surfaces 7 in each layer to apply fixation points 5 and 6.

### Example 3

Fig. 7 shows a sensor with a sandwich structure, which differs from Examples 1 and 2 in that the fixation points 6 not used for electrical connection extend into the surface pattern 3. While in the previous examples of sensor configuration, the fixation points 6 were arranged around the circumference of the substrates 1, in this example they copy the conductive pattern and become part of it, making the fixation more reliable in terms of the strength of the sandwich structure.

### Example 4

Fig. 8 shows a sensor with a sandwich structure, which has surface conductive patterns 2, 3, and 8 on both the front and back sides of substrates 1. Patterns 2 and 3 alternate in layers on the front sides of substrates 1, with the opposite back pattern 8 located on each back side of substrate 1. This results in a higher density of turns of the resulting coil of the sensor.

### Example 5

Fig. 9 shows a sensor with a sandwich structure, which has an upper additional substrate 9 arranged in the first position of the sandwich structure without surface patterns 2, 3, and 8. The material composition of the upper additional substrate 9 is the same as that of substrates 1 bearing surface patterns 2, 3, and possibly also 8. The aim of the upper additional substrate 9 is to protect the surface pattern 2 of the first substrate 1.

### Example 6

Fig. 10 shows a sensor with a sandwich structure, which is provided with both an upper additional substrate 9 and a lower additional substrate 10.

### Example 7

Figs. 11 and 12 show a sensor with a sandwich structure, which has an upper additional substrate 11 provided with an upper field of points 12 made of the material of surface patterns 2 and 3. The upper field of points 12 is symmetrical, and the amount of material used to create the upper field of points 12 corresponds, with tolerance, to the amount of material forming the adjacent surface pattern 2.

Fig. 12 shows that the sensor is provided with a lower additional substrate 13 with its own lower field of points 14. The lower field of points 14 is symmetrical, and the amount of material used to create the lower field of points 14 corresponds, with tolerance, to the amount of material forming the adjacent surface pattern 3.

Both fields 12 and 14 are so-called "compensation layers", with the appropriate volume of material in relation to surface patterns 2 and 3 making it possible to achieve a balanced flow of β-electrons knocked out by neutron flux in all layers of the sensor, thereby compensating for RIC and RIEMF effects.

Fig. 13a shows that the upper field of points 12 and the lower field of points 14 are not connected to a coil formed by turns from individual layers of the sandwich structure.

### Example 8

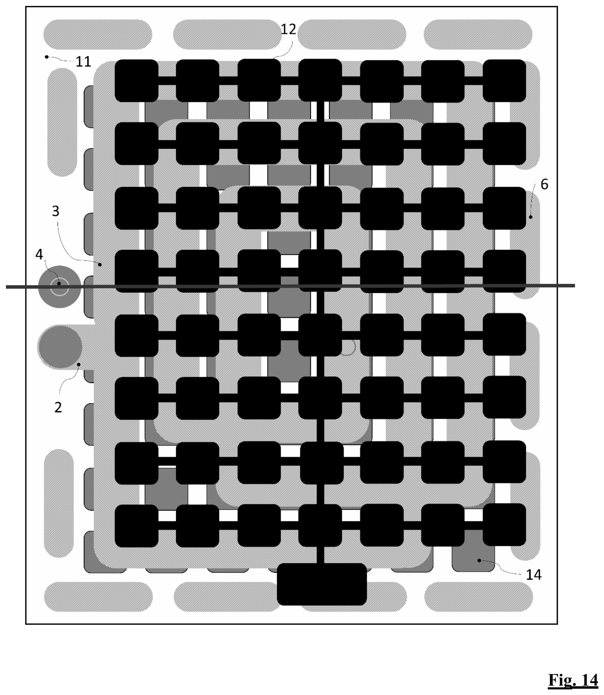

Figs. 14 and 15 show a sensor with a sandwich structure, which differs from Example 7 in that both fields of points 12 and 14 are electrically connected into comb structures 15 to remove electrical charge.

### Example 9

Fig. 4 of the previous example illustrating the projections of two layers with surface patterns 2 and 3 shows that these surface patterns 2 and 3 occupy a significant part of the projection of the sandwich structure in one axis of space. Appropriate design of the surface patterns in other layers of the sandwich structure makes it possible to occupy almost the entire projection of the sandwich structure with the active area of the coil turns.

At the same time, illustrative Figs. 3b and 3c show that in the other axes the surface patterns do not form a continuous area in the composite projection, therefore in these other axes the sensor is not very sensitive to the magnetic field. Shown in more detail in Fig. 13a and Fig. 17, where the projections of the conductive patterns occupy approximately 50% of the total projection. Compared to a conventional coil with a turn wound on a core (see Fig. 13b), this is half the resulting projection. A magnetic field directed away from the main axis of measurement therefore acts on the invented sandwich structure with a lower side effect.

### Example 10

Fig. 16 shows a schematic example of so-called "twisted connection of surface patterns of the sensor" to minimize signal sensitivity from unwanted directions.

This addition of the projections of individual surface patterns into a continuous area of the total projection of the sandwich structure is called the new term "3D twisted" winding of the resulting coil when designing specific configurations of the invented sensors.

### Example 11

Fig. 17 shows a schematic diagram of the resulting coil of the embodiment of the sensor with a sandwich structure, which, thanks to the arrangement in space and interconnection of the individual layers, achieves signal conduction in constant or mutually close temperature gradients and with the potential for mutual subtraction of these gradients.

Neutron ionising radiation gradually penetrates the layers of the surface patterns, whereby the individual layers of the surface patterns are bombarded with particles unevenly and local thermocouples are formed in the surface patterns. In order for the measurement signal to correspond approximately to the mean value and not to be gradually influenced by the difference in the gradients of the thermoelectric effect during its passage through the coil - a continuous loop composed of individual layers, the electrical interconnection of the layers of the surface patterns is carried out by connecting the first pair of layers in the order of the sandwich structure with the last pair of layers in the order of the sandwich structure, followed by connection of the penultimate pair of layers in the order of the sandwich structure and the second pair of layers of the sandwich structure. This "swinging" like on a U-ramp is repeated until all layers of the surface patterns are connected in this way into a single loop of the coil.

This achieves the most even balance of the possible formation of local thermocouples in the winding, thereby compensating for the RITES and TIEMF effects and at the same time minimizing the area of the combined projection of the surface patterns in the direction perpendicular to the sensing axis of the sensor. This architecture can preferably be used in both secondary axes of the sensor.

This interconnection of individual surface patterns is called the new term "nuofilar" winding of the resulting coil when designing specific configurations of the invented sensors.

### Example 12

Fig. 18 shows a schematic diagram of the connection of the invented coil combining 3D twisted and nuofilar windings on the coil in the created sandwich structure. The substrates 1 have more than one metal-plated hole 4 to enable this design.

### Industrial applicability

The magnetic field sensor and the method of manufacturing the same according to the present invention will find their application in the field of research and energy, especially in the production of fusion energy.

### List of reference numerals

- 1: ceramic substrate
- 2: first surface pattern
- 3: second surface pattern
- 4: metal-plated hole
- 5: fixation point with electrically conductive connection of layers of the sandwich structure
- 6: fixation point without electrically conductive connection of layers of the sandwich structure
- 7: contact surface
- 8: back pattern
- 9: upper additional substrate
- 10: lower additional substrate
- 11: compensating upper additional substrate with field of points
- 12: upper field of points
- 13: compensating lower additional substrate with field of points
- 14: lower field of points
- 15: comb structure

## Claims

1. A magnetic field sensor comprising at least one wound electrical conductor to induce an electrical voltage by a penetrating alternating magnetic field, further comprising insulation of the turns of the wound electrical conductor to prevent electrical contact between them, and further comprising electrical contacts arranged at the ends of the wound electrical conductor to connect an external device, **characterized in that** it comprises at least two substrates (1) made of ceramic insulating material arranged in a sandwich structure with spacings between the substrates of at least 0.2 mm, further the wound electrical conductor is formed by at least one surface pattern (2) arranged on at least one side of the substrates (1), and further the individual substrates (1) have metal-plated holes (4) for electrical connection of their back and front sides, with the electrical contacts being arranged from the outside of the sandwich structure, and further the ceramic insulating material of the substrates (1) is from the Al₂O₃, AlN, or MgAl₂O₄ group, and the surface pattern (2) is made of a material from the Cu, Pt, W group.

2. The sensor according to claim 1, **characterized in that** adjacent surface patterns (2, 3) overlap by a maximum of 20%.

3. The sensor according to claim 1 or 2, **characterized in that** at least one fixation point (6) is formed between adjacent substrates (1) from the material of the surface pattern (2).

4. The sensor according to claim 1 or 2, **characterized in that** at least one fixation point extending into adjacent surface patterns (2, 3) for their electrical connection is formed between adjacent substrates (1) from the material of the surface pattern (2).

5. The sensor according to any of claims 1 to 4, **characterized in that** the sandwich structure comprises at least one additional substrate (9, 10) without the surface pattern, wherein the additional substrate (9, 10) is arranged at the beginning and/or at the end and/or inside the sandwich structure.

6. The sensor according to claim 5, **characterized in that** the additional substrate (9, 10) arranged at the beginning and/or at the end of the sandwich structure is provided on the side facing away from the sandwich structure with a field of points (12, 14) or a comb structure (15) made of electrically conductive material.

7. The sensor according to claim 6, **characterized in that** the total volume of the material forming the field of points (12, 14) or the comb structure (15) is equal to the volume of the material of the adjacent surface pattern (2, 3, 8) with a tolerance of no more than ± 20%.

8. The sensor according to any of claims 1 to 7, **characterized in that** the surface patterns of the sandwich structure are connected into a single loop, wherein the combined projection of the surface patterns (2, 3, 8) in a direction perpendicular to the sensing axis of the sensor forms a magnetically active continuous surface with a content of up to 50% of the total projection area of the surface patterns.

9. The sensor according to any of claims 1 to 8, **characterized in that** the surface patterns (2, 3, 8) of the sandwich structure are connected into a loop, wherein the beginning of the loop gradually includes the surface patterns of the odd positions of the sandwich structure in order from the first to the last, and the end of the loop gradually includes the surface patterns of the even positions of the sandwich structure in order from the last to the first.

10. The sensor according to any of claims 1 to 8, **characterized in that** the surface patterns (2, 3, 8) of the sandwich structure are connected into a loop, wherein the beginning of the loop includes the first surface pattern in the order of the sandwich structure and the following last surface pattern in the order of the sandwich structure, the middle of the loop includes the second and nth surface patterns in the order of the sandwich structure and the following penultimate and nth patterns in the order of the sandwich structure, and at the same time, the end of the loop includes the middle surface patterns in the order of the sandwich structure.

11. The sensor according to any of claims 1 to 8, **characterized in that** the surface patterns (2, 3, 8) of the sandwich structure are connected into a loop, wherein the beginning of the loop includes a pair of surface patterns of the first in the order of the sandwich structure and the following pair of surface patterns of the last in the order of the sandwich structure, wherein the order of the layers of surface patterns is maintained, the middle of the loop includes the second and nth pairs of surface patterns in the order of the sandwich structure and the following penultimate and nth pairs of surface patterns in the order of the sandwich structure, and at the same time, the end of the loop includes the middle pair of surface patterns in the order of the sandwich structure.

12. A method of manufacturing a magnetic field sensor created according to any of claims 1 to 11, **characterized in that** the surface patterns (2, 3, 8) are first created on substrates (1) using the method of selective printing and firing from a material from the Cu, Pt, W group, and subsequently the individual substrates (1) with fired surface patterns (2, 3, 8) are assembled into a sandwich structure and the surface patterns (2, 3, 8) are connected into a continuous electrically conductive path, whereby the sandwich structure is fixed.
